# EUROPEAN PATENT SPECIFICATION

(11) **EP 4 303 571 B1**
(45) Date of publication and mention of the grant of the patent: **21.01.2026**
(21) Application number: 23181729.7
(22) Date of filing: 27.06.2023
(51) Int. Cl.: G01N 21/65, B82Y 40/00

(54) **METHOD OF PRODUCING GOLD-COATED INDIUM PHOSPHIDE NANOSTRUCTURES AND THEIR USE IN SURFACE-ENHANCED RAMAN SCATTERING MEASUREMENTS**
VERFAHREN ZUR HERSTELLUNG GOLDBESCHICHTETER INDIUMPHOSPHID-NANOSTRUKTUREN UND IHRE VERWENDUNG BEI OBERFLÄCHENVERSTÄRKTEN RAMAN-STREUUNGSMESSUNGEN
PROCEDE DE PRODUCTION DE NANOSTRUCTURES DE PHOSPHURE D'INDIUM REVETUES D'OR ET LEUR UTILISATION DANS LES MESURES DE DIFFUSION RAMAN ACCENTUEE PAR LA SURFACE

(30) Priority: 06.07.2022 PL 44165822
(43) Date of publication of application: 10.01.2024
(73) Proprietor: Uniwersytet Warszawski, 00-927 Warszawa (PL); SIEC BADAWCZA LUKASIEWICZ - INSTYTUT MIKROELEKTRONIKI I FOTONIKI, 02-668 Warszawa (PL)
(72) Inventor: KRAJCZEWSKI, Jan, 03-966 Warszawa (PL); KUDELSKI, Andrzej, 02-886 Warszawa (PL); TURCZYNIAK-SURDACKA, Sylwia, 02-793 Warszawa (PL); DUMISZEWSKA, Ewa, 00-710 Warszawa (PL); CZOLAK, Dariusz, 02-945 Warszawa (PL)
(74) Representative: AOMB Polska Sp. z.o.o.

(56) References cited:
- ZHANG JUNCE ET AL: "Raman spectroscopy of indium phosphide nanowire networks coated with gold clusters", JOURNAL OF MATERIALS SCIENCE: MATERIALS IN ELECTRONICS, CHAPMAN AND HALL, LONDON, GB, vol. 25, no. 11, 17 August 2014 (2014-08-17), pages 4867 - 4871, XP035400671, ISSN: 0957-4522, [retrieved on 20140817], DOI: 10.1007/S10854-014-2245-Z
- CHEN JIANING ET AL: "Surface-enhanced Raman scattering of rhodamine 6G on nanowire arrays decorated with gold nanoparticles", vol. 19, no. 27, 28 May 2008 (2008-05-28), Bristol, GB, pages 275712, XP093101503, ISSN: 0957-4484, Retrieved from the Internet <URL:https://iopscience.iop.org/article/10.1088/0957-4484/19/27/275712/pdf> DOI: 10.1088/0957-4484/19/27/275712
- M�RTENSSON T ET AL: "Fabrication of individually seeded nanowire arrays by vapour-liquid-solid growth; Fabrication of individually seeded nanowire arrays by vapour-liquid-solid growth", NANOTECHNOLOGY, INSTITUTE OF PHYSICS PUBLISHING, BRISTOL, GB, vol. 14, no. 12, 1 December 2003 (2003-12-01), pages 1255 - 1258, XP020067409, ISSN: 0957-4484, DOI: 10.1088/0957-4484/14/12/004
- ANDREW J LOHN ET AL: "Epitaxial growth of ensembles of indium phosphide nanowires on various non-single crystal substrates using an amorphous template layer", JOURNAL OF CRYSTAL GROWTH, vol. 315, no. 1, 9 September 2010 (2010-09-09), pages 157 - 159, XP028137745, ISSN: 0022-0248, [retrieved on 20100909], DOI: 10.1016/J.JCRYSGRO.2010.08.050
- WOO ROBYN L. ET AL: "Kinetic Control of Self-Catalyzed Indium Phosphide Nanowires, Nanocones, and Nanopillars", NANO LETTERS, vol. 9, no. 6, 6 May 2009 (2009-05-06), pages 2207 - 2211, XP093304378, ISSN: 1530-6984, Retrieved from the Internet <URL:https://pubs.acs.org/doi/pdf/10.1021/nl803584u?ref=article_openPDF> DOI: 10.1021/nl803584u
- KRAJCZEWSKI JAN ET AL: "New, epitaxial approach to SERS platform preparation - InP nanowires coated by an Au layer as a new, highly active, and stable SERS platform", APPLIED SURFACE SCIENCE, vol. 607, 1 January 2023 (2023-01-01), pages 155096, XP093101411, DOI: 10.1016/j.apsusc.2022.155096

## Description

The invention relates to a method of producing gold-coated InP nanostructures, as well as the use of gold-coated InP nanostructures as highly efficient, reproducible, and stable platforms for measurements of surface-enhanced Raman scattering (SERS).

In prior art, one of the most important methods of preparing a SERS platform is to coat a highly ordered semiconductor layer with plasmonic materials (like Au, Ag or Cu). Certain semiconductor nanosurfaces, such as TiO₂ *[*P. Roy, D. Kim, K. Lee, E. Spiecker, P. Schmuki, TiO2 nanotubes and their application in dye-sensitized solar cells, Nanoscale, 2 (2010) 45-59*;* K. Arifin, R. M. Yumus, L. J. Minggu, M. B. Kassim, Improvement of TiO2 nanotubes for photoelectrochemical water splitting: Review, Int. J. Hydrog., 46 (7) (2021) 4998-5024*]* or ZrO₂ *[*W. Jiang, J. He, J. Zhang, J. Lu, S. Yuan, B. Liang, Preparation and photocatalytic performance of ZrO2 nanotubes fabricated with anodization process, Appl. Surf. Sci., 307 (2014) 407-413*;* L. Li, D. Yan, J. Lei, J. He, S. Wu, F. Pan, Fast fabrication of highly regular and ordered ZrO2 nanotubes, Mater. Lett., 65 (9) (2011) 1434-1437*],* can be manufactured using the anodising method, or others, like GaN, using the photoetching method [*M*. *Bańkowska, J. Krajczewski, I. Dzi* 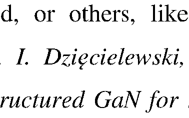 *cielewski, A. Kudelski, J. L. Weyher, Au-Cu Alloyed Plasmonic Layer on Nanostructured GaN for SERS Application, J. Phys. Chem. C, 120 (3) (2016) 1841-1846; J. L. Weyher, B. Bartosewicz, I. Dzi* 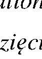 *cielewski J. Krajczewski, B. Jankiewicz, G. Nowak, A.Kudelski, Relationship between the nano-structure of GaN surfaces and SERS efficiency: Chasing hot-spots, Appl. Surf. Sci., 466 (2019) 554-531].*

It is known from prior art that templates of polystyrene nanospheres can also be used as an SERS platform after deposition of the plasmonic layer *[*W. Cai, W. Wang, L. Lu, T. Chen, Coating sulfonated polystyrene microspheres with highly dense gold nanoparticle shell for SERS application, Colloid Polym Sci., 291 (2013) 2023-2029*;* Y. Zhao, W. Luo, P. Kanda, H. Cheng, Y. Chen, S. Wang, S. Huan, Silver deposited polystyrene (PS) microspheres for surface-enhanced Raman spectroscopic-encoding and rapid label-free detection of melamine in milk powder, Talanta, 113 (2013) 7-13*].*

In prior art, there are various described types of nanostructural semiconductor surfaces, which have been coated with plasmonic nanoparticles *[*R. Ambroziak, J. Krajczewski, M. Pisarek, A. Kudelski, Immobilization of Cubic Silver Plasmonic Nanoparticles on TiO2 Nanotubes, Reducing the Coffee Ring Effect in Surface-Enhanced Raman Spectroscopy Applications, ACS Omega, 5 (23) (2020) 13963-13972*]* instead of depositing a plasmonic layer.

In prior art, there are various known methods applied in the growth of InP nanowires, including MOVPE (metalorganic vapour-phase epitaxy) and MBE (molecular-beam epitaxy). According to prior art, Woo et al.: "Kinetic Control of Self-Catalyzed Indium Phosphide Nanowires, Nanocones, and Nanopillars", NANO LETTERS, Vol. 9, No. 6, p. 2207-2211, 2009, , in a temperature of approx. 350°C nanowires are produced with a constant diameter of ~50 nm, regardless of their length. Nanocones form in a temperature of approximately 395°C, and eventually nanopillars form in a temperature above 400°C. Increasing the growth temperature and maintaining a constant molar ratio of P/In cause the generation of conical and pillar-shaped rather than wire-shaped InP nanostructures. The height of the nanostructures decreases along with a decrease in the TMIn stream. These data show that nanowires grow best in low temperatures (below 400°C) and with a low molar ratio of P/In. If too much TMIn is supplied into the reactor chamber, and the P/In ratio is too high, there will be a rapid increase in the thickness of the nanowire, but the length of the nanowire will remain the same. When there are not enough indium atoms in the reaction zone of a reactor, the thickness of the nanowire will decrease rapidly. In order to grow higher nanowires with stable thickness along them, it is necessary to increase the growth time of the nanowire, or the stream of trimethylindium (TMIn).

Document Zang Junce et al: "Raman spectroscopy of indium phosphide nanowire networks coated with gold clusters ", Journal of Material Science, 2014, vol. 25, no. 11, pages 4867-4871 discloses enhanced Raman signal of the longitudinal optical phonon mode in indium phosphide nanowire networks with gold coating of up to 5 nm thickness was observed experimentally to further study the phonon spectrum of nanowire networks. Indium phosphide nanowire networks coated with different nominal thicknesses of gold were prepared and optically studied. Raman spectroscopy, scanning electron microscopy, photoluminescence spectroscopy and Ranam spectroscopy were used to study the dependence of surface morphology and phonon modes of the nanowire networks on the nominal thickness of the gold coating.

Document Jianing Chen et al, Nanotechnology, 2008, 19, 275712 discloses the surface-enhanced Raman scattering absorbed on Au nanoparticles attached to InP nanowires. Nanowire arrays act as frameworks for effective SERS substrate with a significantly higher Raman signal sensitivity than a planar framework of Au nanoparticles adsorbed two-dimensionally on a flat surface. The SERS signal increases with time during continuous laser illumination.

Martensson T. et al: " Fabrication of individually seeded nanowire arrays by vapour-liquid-solid growth" Nanotechnology, 2003, 14, pages 1255-1258 discloses a method of synthesizing arrays of individually seeded nanowires. An electron beam lithography and metal lift-off method was used to patten InP(111)B substrate with catalysing gold particles. Nanowires were grown from the gold particles using metal-organic vapour phase epitaxy.

Andrew J. Lohn, et al. "Epitaxial growth of ensembles of indium phosphide nanowires on various non-single crystal substrates using an amorphous template layer", Journal of Crystal Growth, 2011, 315, pages 157-159*,* discloses Indium phosphide nanowires grown by metal organic chemical vapour deposition on hydrogenated silicon (Si:H) surfaces prepared on various non-single crystal substrates.

One of the main problems related to the use of semiconductor surfaces coated with noble metals is their contamination. During synthesis, certain chemical compounds may become trapped on the surface of nanostructures. This type of problem is often observed in the case of F- during the formation of TiO₂ and ZrO₂ nanotubes. One of the possibilities of removing such contaminations is annealing. However, the annealing of WOx substrates leads to a change in their morphology due to the melting of the oxide layer.

Moreover, it is known from prior art that the potential of InP is approximately 1.35 eV [R. Toufanian, A. Piryatinski, A. H. Mahler, R. Iyer, J. A. Hollingsworth, A. M. Dennis, Bandgap Engineering of Indium Phosphide-Based Core/Shell Heterostructures Through Shell Composition and Thickness, Front. Chem., 6 (2018) 1-12*]* (above 920 nm), and thus it is beyond the visible range. For this reason, InP has not yet been recognised as a material suitable for the development of the SERS platform. During the performed UV-DRS measurements, the transitions of the forbidden band are above the range of the spectrophotometer. For this reason, InP has not yet been used as a substrate for SERS measurements.

Unexpectedly, it was observed that after deposition of an Au layer on nanowires, in each analysed case a new broad peak is generated within a range of 450-700 nm. The intensity of the peak increased along with an increase in the thickness of the deposited Au layer. The new band within the visible range is related to surface plasmon resonance (SPR) appearing in the deposited Au layer. The presence of the SPR band after the deposition of the Au layer on the surface of the InP nanowire is responsible for the SERS activity of the samples.

The purpose of the invention was to provide a reproducible method of producing InP nanowires coated with an Au layer, enabling control of the diameter, length, and distance between the neighbouring nanowires. This method enables modification of the optical properties, and thus an increase in the intensity of enhancement for a specific wavelength of exciting radiation.

The object of the invention is a method of producing gold-coated InP nanostructures, in which:
(a) in the first step, on a monocrystalline InP substrate, nanowires are grown using the method of metalorganic chemical vapour deposition, by introducing trimethylindium and phosphine in a constant manner into the reactor,
   wherein the carrier gas is hydrogen,
   wherein the molar ratio of the flow rate of phosphine to the flow rate of trimethylindium is no higher than 1000,
   wherein, during the introduction of trimethylindium and phosphine into the reactor, a constant temperature within a range of 370 to 390°C and a pressure of 100 mbar are maintained;
(b) in the second step, the surface of the grown nanowires is coated with a gold layer by plasma spraying with a direct current of 20 mA.

Preferably, before the introduction of trimethylindium and phosphine into the reactor, the monocrystalline substrate is heat-treated in a hydrogen atmosphere in a temperature of 650°C for at least 3 minutes.

Preferably, a monocrystalline substrate with an orientation of <111> is used.

Preferably, a monocrystalline substrate with dimensions of 20 x 20 cm is used.

Preferably, only trimethylindium is introduced into the reactor, and the introduction of phosphine begins after the appearance of the first droplets of indium on the InP substrate.

Preferably, the flow rate of trimethylindium ranges from 10 to 20 ml/min.

Preferably, the flow rate of phosphine is 300 ml/min.

Preferably, plasma spraying is performed for a time of 3 to 7 minutes.

Another aspect of the invention is use of gold-coated InP nanostructures as a platform for the measurements of surface-enhanced Raman scattering.

Preferably, para-mercaptobenzoic acid is used as a model molecule in the measurements.

Preferably, before performing the measurement, InP nanowires coated with a gold layer are submerged for 24 hours in a solution of para-mercaptobenzoic acid, and subsequently rinsed in water and dried for 1 hour in room temperature.

The advantage of the invention is providing the possibility to eliminate contaminations of an examined sample with elements which were included in the composition of the substrates used so far, high reproducibility, high SERS enhancement factors, and the possibility to easily control the morphology of nanowires.

In the case of InP nanowires produced using the method according to the invention, epitaxial growth ensures purity of the sample. An EDS analysis (using the energy-dispersive X-ray spectroscopy method) does not identify any elements except In, P, and Au. This is why the InP@Au SERS platform with nanowires may be used without any preliminary treatment.

The object of the invention is presented in embodiments in a drawing, in which:
Fig. 1 presents the Raman spectrum of InP nanowires. Excitation line: 633 nm;
Figs. 2a-2b present an SEM image (acquired using the scanning electron microscopy method) of InP nanowires, wherein Fig. 2a presents the image at an angle of 0°, Fig. 2b-at an angle of 54°,
Fig. 2c presents the image of a cross-section of the InP nanowires of Figs. 2a and 2b;
Fig. 3a presents an SEM image of InP nanowires before coating with an Au layer;
Figs. 3b-3d present SEM images of InP nanowires after the deposition of an Au layer, wherein Fig. 3b presents an image for a deposition time of 3 min., Fig. 3c-for a deposition time of 5 min., and Fig. 3d-for a deposition time of 7 min.;
Fig. 3e presents a chart showing the thickness of the deposited Au film as a function of time, with a direct current of 20 mA;
Figs. 4a-4h present cross-sectional FIB images (acquired with the use of a focused ion beam) of Au@InP nanowires with varying thickness of Au;
Fig. 5 presents UV-DRS spectra (acquired using the ultraviolet-visible diffuse reflectance spectroscopy method) of: (a) InP nanowires without coating, (b)-(d) InP nanorods coated with an Au layer with variable thickness [(b)-Au deposition for 3 minutes, (c)-for 5 minutes, (d)-for 7 minutes];
Fig. 6 presents SERS spectra of p-MBA (para-mercaptobenzoic acid) recorded on InP nanowires coated with an Au layer deposited for various durations: a) 3 minutes, b) 5 minutes, and c) 7 minutes.

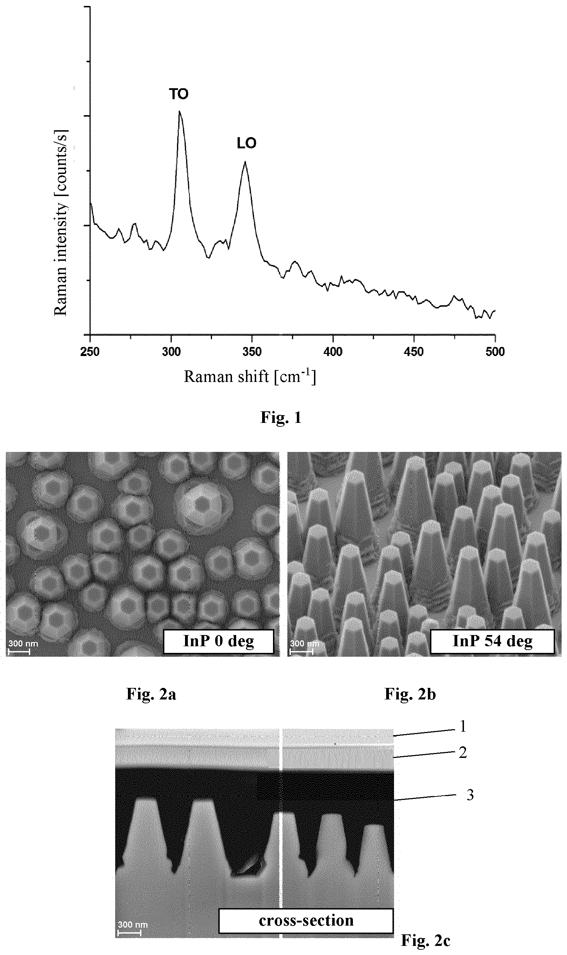

Fig. 1 presents the Raman spectrum of InP nanowires showing two peaks within the range of low frequencies (280-350 cm⁻¹) typical for the oscillation of heavy atoms, and thus for the vibrations of phonons. The first peak located at 305 cm⁻¹ is associated with a transverse optical (TO) phonon, while the second peak located at 345cm⁻¹ may be attributed to a longitudinal optical (LO) phonon. It should be noted that the Raman stripes of InP nanowires do not overlap with most stripes of commonly used Raman reporter molecules, since most Raman reporters generate the strongest Raman stripes with a much higher Raman shift than the shift of the phonon bands of InP. Moreover, after deposition of the gold layer, the Au layer completely covers InP signals, and these signals are almost completely invisible in SERS spectra measured with the use of other substrates.

Figs. 2a-2b present SEM images of InP nanowires at an angle of 0° (fig. 2a) and 54° (fig. 2b), and fig. 2c presents a cross-section of InP nanowires, 1 standing for an ion-deposited Pt layer, 2-for an electron-deposited Pt layer, and 3-for a protective layer containing carbon. SEM micrographs of the samples showed uniformly distributed InP nanowires based on a hexagonal shape at their base. The average diameter of InP nanowires was estimated at 189.3±9.3 nm for the top and 544.2±45.9 nm for the base, while the length of the nanowires was estimated at 798.8 nm±251.2 nm.

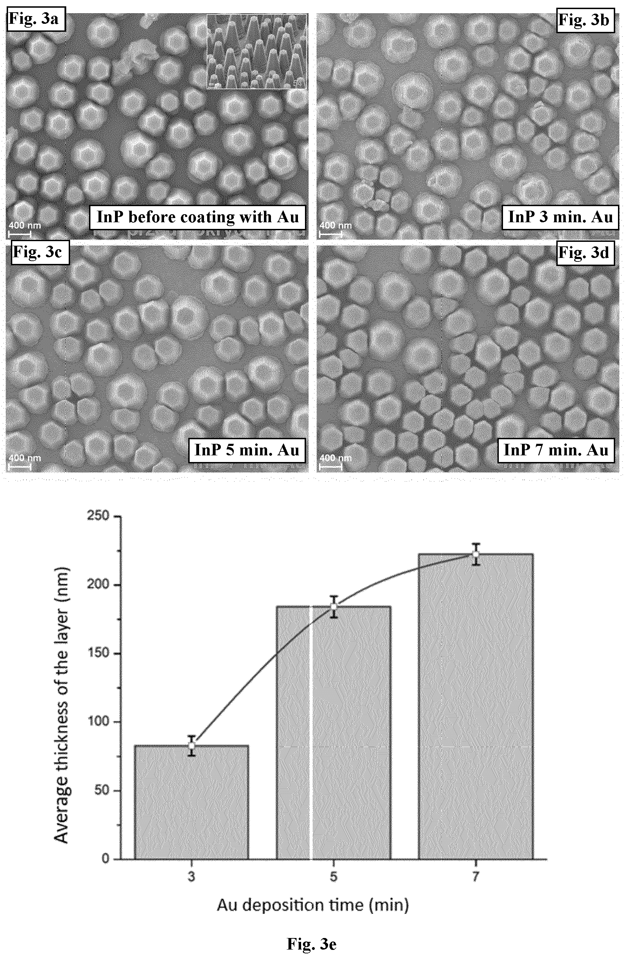

Figs. 3b-3d present SEM images of InP nanowires coated with an Au layer of varying thickness. It was concluded that even during deposition of a rather thick layer, such as 200 nm, the morphology of the nanowire is still not concealed by the Au layer, but it remains predominant. This result is of key significance for obtaining a high EF factor in SERS spectroscopy. It should be noted that, along with an increase in the thickness of the deposited Au layer, the distance between the neighbouring nanowires decreases; at the same time, the surface plasmon resonance is strengthened, which has strong impact on an increase in the activity of SERS. However, in numerous latest SERS platforms based on a nanostructural semiconductor surface, such as TiO₂ or ZrO₂ nanotubes, the deposited plasmonic layer cannot be too thick, since the deposited layer may easily cover the morphology of the nanotubes. For example, in the case of ZrO₂ nanotubes it was concluded that an applied Au layer thicker than 30 nm is sufficient to cover the morphology of the nanotubes, which leads to reducing the intensity of SERS *[*J. Krajczewski, S. Turczyniak-Surdacka, M. Dziubaltowska, R. Ambroziak, A. Kudelski, Ordered zirconium dioxide nanotubes coated with an evaporated gold layer as reversible, chemically inert and very efficient substrates for surface-enhanced Raman scattering (SERS) measurement, Spectrochim. Acta A, 275 (2022) 121183*].* In the present invention, even a deposited Au layer of 200 nm does not lead to covering the morphology of InP nanowires.

For comparison, fig. 3a presents SEM images of InP nanowires before being coated with an Au layer. On the other hand, fig. 3e presents the dependence of the thickness of the deposited Au film as a function of time, with a direct current of 20 mA. According to this, the average thickness of the deposited Au layer was 82.7±7.0 nm after 3 minutes, 184.1±7.7 nm after 5 minutes, and 221.4±7.7 nm after 7 minutes of Au deposition with a direct current of 20 mA.

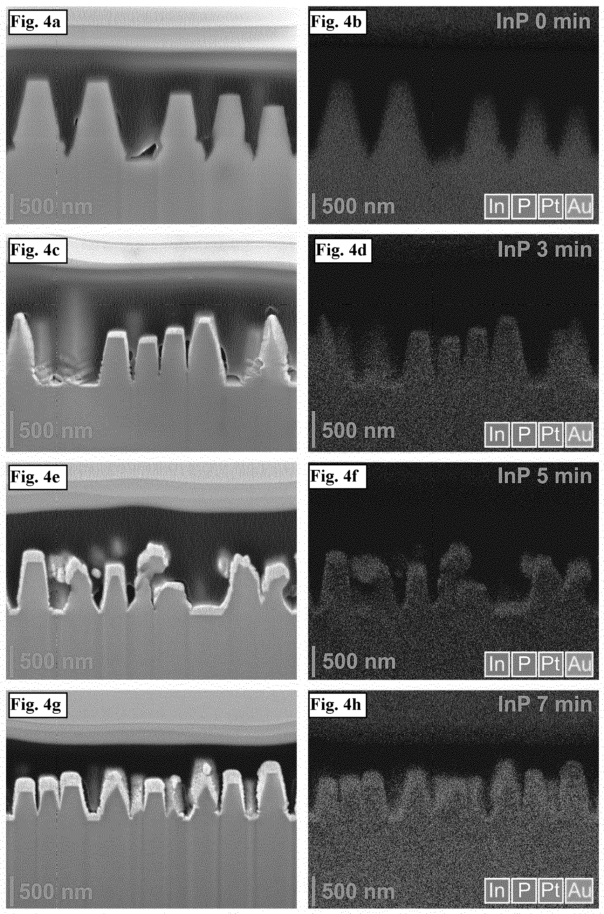

EDS mapping was also performed for cross-sectional images acquired with the SEM method using FIB, the cross-sectional images being presented in figs. 4a, 4c, 4e, and 4g, with their respective images mapped using the EDS method in figs. 4b, 4d, 4f, and 4h. Elemental mapping proved that the nanowires were made of pure InP, uniformly dispersed in the nanowires. In the case of samples coated with an Au layer, EDS measurements proved that Au penetrates spaces between the neighbouring nanowires. The same behaviour was observed in all cases, regardless of the thickness of the deposited Au layer.

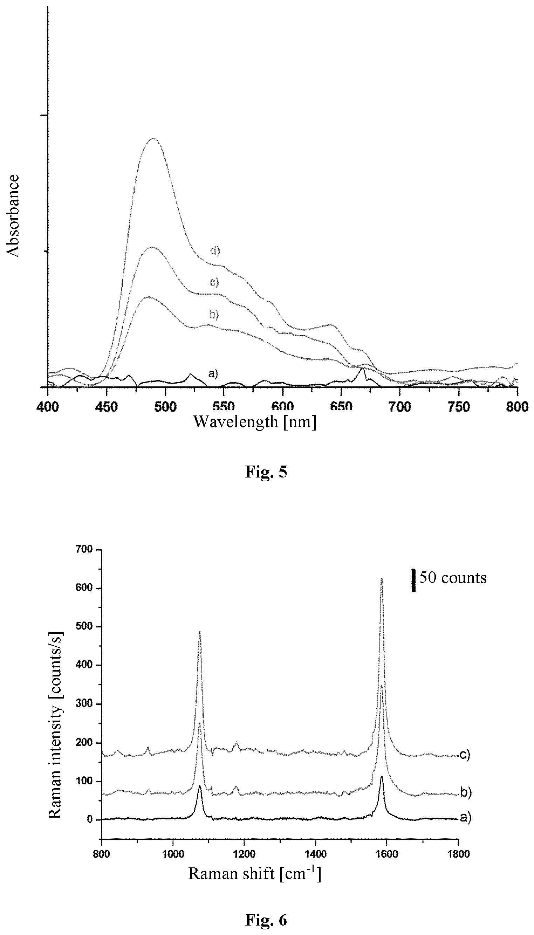

The SERS spectra of p-MBA recorded on InP@Au nanowires are presented in fig. 6. Para-mercaptobenzoic acid was used as a model molecule for SERS measurements. A monolayer of p-MBA was adsorbed on the surface of Au@InP by submerging the sample in a saturated aqueous solution of p-MBA for 24 h. This led to the creation of a chemisorbed monolayer of p-MBA molecules connected to the surface by Au-S bonds. This procedure led to the same surface concentrations of p-MBA for all the samples. A typical SERS spectrum of p-MBA is dominated by two strong bands at 1077 cm⁻¹ and 1587 cm⁻¹, which are caused by v12 and v8a vibrations of the aromatic ring, respectively [A. Kudelski, Surface-enhanced Raman scattering study of monolayers formed from mixtures of 4-mercaptobenzoic acid and various aromatic mercapto-derivative bases, J. Raman Spectrosc., 40 (12) (2009) 2037-2043*, https:*//*doi.org*/*10.1002*/*jrs.2367].* A weaker band in the SERS spectrum of p-MBA, at 1185 cm⁻¹, is caused by vibrations of d(C-H) [A. Michota, J. Bukowska, Surface-enhanced Raman scattering (SERS) of 4-mercaptobenzoic acid on silver and gold substrates, J. Raman Spectrosc., 34 (1) (2003) 21-25, https://doi.org/10.1002/jrs.928*].*

It was also concluded that the enhancement of SERS increases along with an increase in the thickness of the deposited Au layer. These results are the effect of two various mechanisms. First, the UV-DRS measurements performed earlier proved that the SPR band increases its intensity along with an increase in the thickness of the deposited Au layer. This is why it is obvious that greater enhancement of SERS could be achieved for InP@Au samples with the thickest Au layer. The second parameter is the generation of a larger number of 'hot spots' on the surface of the samples. A thicker deposited Au layer caused reduction of the distance between the neighbouring nanowires. Reduction of the space between the neighbouring InP nanowires led to the generation of a larger number of 'hot spots', which leads to considerable enhancement of the signal being measured.

The SERS spectrum of the p-MBA monolayer was also measured on glass coated with an Au layer with the same thickness (as reference) as on InP nanowires. The enhancement of the spectra being measured is significantly weaker than the one recorded on InP@Au nanowires. This is why these results indicate that enhancement of the Raman signal is more associated with InP nanostructures than with the deposited Au film.

For each obtained sample, 100 SERS spectra were measured in various areas, followed by the plotting of averaged spectra. Au@InP nanowires exhibit good reproducibility; RSD for all the recorded SERS spectra falls within a range of 5-10%. It should be mentioned that this SERS platform is also characterised by very good temporal stability; it was observed that even after 1 month, the SERS platform retains almost 100% (98%) of the initial activity of SERS.

### Embodiments of the invention:

Raman spectra were measured using a Horiba Jobin-Yvon Labram HR800 spectrometer connected to an Olympus BX40 confocal microscope with a long distance 50x lens. The Raman spectrometer was provided with a CCD detector cooled using the Peltier method (1024 x 256 pixels) and a holographic grid of 600 grooves per mm, while an He-Ne laser supplied exciting radiation with a wavelength of 633 nm.

The diffuse reflectance spectrum (DRS) of the samples was recorded by means of a UV-VIS spectrometer (Shimadzu UV-3600) provided with an integrating sphere.

The surface morphology of the nanowires was examined by means of a Crossbeam 550X (ZEISS) FIB-SEM microscope with an acceleration voltage of 5 kV for imaging in a planar view, and 6 kV for EDS mapping and cross-sectional imaging (Oxford Instruments). The diameter of the nanowires was estimated on the basis of SEM images in a planar view, while their length was calculated on the basis of SEM views in a cross-section. A source of Ga+ was used to characterise the cross-section of the structure created by FIB. Before the measurements, the surface was protected by a droplet of hairspray. Platinum was deposited on a selected area (2 kV, 4 nA-an electron beam, and 30 kV, 300 pA-an ion beam) in order to protect nanowires against damage during the milling process. A cross-section sufficient for further characterisation can be obtained by cutting with 30 kV, 3 nA, and subsequently final polishing with 30 kV, 300 pA at +2° relative to the inclination.

### Embodiment 1. Synthesis of InP nanowires

InP nanowires were grown using the epitaxial method. It is a process of growing a monocrystalline semiconductor layer on a monocrystalline substrate in a crystallographic direction corresponding to the orientation of the substrate. The used InP platform had an orientation of <111>, and thus InP nanowires grew vertically to the ground. A change in orientation of the substrate causes the nanostructures to grow in a different direction, at an angle.

Indium phosphide (InP) nanowires were grown in an AIX 200/4 system using the metalorganic chemical vapour deposition method (MOCVD), without the use of a gold catalyst. InP (111) samples with dimensions of 20 x 20 mm were used as substrates. In order to remove contaminations from the substrate, the substrate is heat-treated in a temperature of 650°C for at least 3 minutes. Trimethylindium (TMIn) and phosphine (PH₃) were used as the precursors of indium and phosphor, respectively. Hydrogen was used as the carrier gas. The impact of the flow of precursors and the growth time on the size and density of InP nanowires was examined. First, the substrate was warmed up to a temperature of 650°C. Next, the introduction of trimethylindium was initiated. Once the first droplets of indium were observed, the introduction of PH₃ into the reactor chamber was initiated. The temperature in the reactor ranged from 370 to 390°C, and the pressure was 100 mbar. The flow of indium was maintained within a range of 10 to 20 ml/min. The flow of PH₃ was maintained at a constant level of 300 ml/min. For all growth processes, the flow of TMIn varied, but the P/In ratio was maintained at a low level, below 1000.

### Embodiment 2. Depositing a gold layer on the surface of InP nanowires

Deposition of a gold layer on substrates made of InP nanowires was accomplished using a Quorum Q150ES sprayer. A direct current of 20 mA was used in all cases. The thickness of the deposited layer was controlled by changing the duration of deposition. The samples were coated for 3, 5, and 7 minutes. The resulting samples are further labelled as Au@InP. The thickness of the deposited Au layer was determined by means of FIB measurements.

### Embodiment 3. SERS measurements

Au@InP nanowires were submerged for 24 hours in a saturated aqueous solution of p-MBA (para-mercaptobenzoic acid) in order to chemisorb this Raman reporter. After chemisorption, the samples were rinsed with water in order to remove excess p-MBA from the surface. Subsequently, the samples were dried in room temperature for 1 hour.
The method according to the invention enables the production of mobile, reproducible and replicable substrates for SERS measurements-especially when it is necessary to eliminate the possibility of contaminating the analysed sample with elements used to produce SERS substrates manufactured so far.

## Claims

1. A method of producing gold-coated InP nanostructures, **characterised in that**
a) in the first step, on a monocrystalline InP substrate, nanowires are grown using the method of metalorganic chemical vapour deposition, by introducing trimethylindium and phosphine in a constant manner into the reactor,
wherein the carrier gas is hydrogen,
wherein the molar ratio of the flow rate of phosphine to the flow rate of trimethylindium is no higher than 1000,
wherein, during the introduction of trimethylindium and phosphine into the reactor, a constant temperature within a range of 370 to 390°C and a pressure of 100 mbar are maintained;
b) in the second step, the surface of the grown nanowires is coated with a gold layer by plasma spraying with a direct current of 20 mA.

2. The method according to claim 1, **characterised in that** before the introduction of trimethylindium and phosphine into the reactor, the monocrystalline substrate is heat-treated in a hydrogen atmosphere in a temperature of 650°C for at least 3 minutes.

3. The method according to claim 1 or 2, **characterised in that** it uses a monocrystalline substrate with an orientation of <111>.

4. The method according to one of the claims 1-3, **characterised in that** it uses a monocrystalline substrate with dimensions of 20 x 20 cm.

5. The method according to one of the claims 1-4, **characterised in that** only trimethylindium is introduced into the reactor, and the introduction of phosphine begins after the appearance of the first droplets of indium on the InP substrate.

6. The method according to one of the claims 1-5, **characterised in that** the flow rate of trimethylindium ranges from 10 to 20 ml/min.

7. The method according to one of the claims 1-6 , **characterised in that** the flow rate of phosphine is 300 ml/min.

8. The method according to one of the claims 1-7, **characterised in that** plasma spraying is performed for a time of 3 to 7 minutes.

9. Use of gold-coated InP nanostructures produced according to the method of claim 1 as a platform for the measurements of surface-enhanced Raman scattering.

10. The use according to claim 9, **characterised in that** para-mercaptobenzoic acid is used as a model molecule in the measurements.

11. The use according to claim 10, **characterised in that**, before performing the measurement, InP nanowires coated with a gold layer are submerged for 24 hours in a solution of para-mercaptobenzoic acid, and subsequently rinsed in water and dried for 1 hour in room temperature

## Patentansprüche

1. Verfahren zur Herstellung von goldbeschichteten InP-Nanostrukturen, **dadurch gekennzeichnet, dass**
a) im ersten Schritt auf einem monokristallinen InP-Substrat Nanodrähte mittels metallorganischer chemischer Gasphasenabscheidung gezüchtet werden, indem Trimethylindium und Phosphin kontinuierlich in den Reaktor eingeleitet werden,
wobei das Trägergas Wasserstoff ist,
wobei das molare Verhältnis der Phosphin-Durchflussrate zur Trimethylindium-Durchflussrate höchstens 1000 beträgt,
wobei während der Einleitung von Trimethylindium und Phosphin in den Reaktor eine konstante Temperatur im Bereich von 370 bis 390°C sowie ein Druck von 100 mbar aufrechterhalten werden;
b) im zweiten Schritt die Oberfläche der gezüchteten Nanodrähte durch Plasmaspritzen mit einem Gleichstrom von 20 mA mit einer Goldschicht überzogen wird.

2. Verfahren nach Anspruch 1, **dadurch gekennzeichnet, dass** vor der Einleitung von Trimethylindium und Phosphin in den Reaktor das monokristalline Substrat in einer Wasserstoffatmosphäre bei einer Temperatur von 650°C für mindestens 3 Minuten wärmebehandelt wird.

3. Verfahren nach Anspruch 1 oder 2, **dadurch gekennzeichnet, dass** ein monokristallines Substrat mit einer <111>-Orientierung verwendet wird.

4. Verfahren nach einem der Ansprüche 1-3, **dadurch gekennzeichnet, dass** ein monokristallines Substrat mit den Abmessungen 20 × 20 cm verwendet wird.

5. Verfahren nach einem der Ansprüche 1-4, **dadurch gekennzeichnet, dass** in den Reaktor ausschließlich Trimethylindium eingeleitet wird und die Einleitung von Phosphin erst nach dem Auftreten der ersten Indiumtropfen auf dem InP-Substrat beginnt.

6. Verfahren nach einem der Ansprüche 1-5, **dadurch gekennzeichnet, dass** die Durchflussrate von Trimethylindium im Bereich von 10 bis 20 ml/min liegt.

7. Verfahren nach einem der Ansprüche 1-6, **dadurch gekennzeichnet, dass** die Durchflussrate von Phosphin 300 ml/min beträgt.

8. Verfahren nach einem der Ansprüche 1-7, **dadurch gekennzeichnet, dass** das Plasmaspritzen über einen Zeitraum von 3 bis 7 Minuten durchgeführt wird.

9. Verwendung der nach dem Verfahren gemäß Anspruch 1 hergestellten goldbeschichteten InP-Nanostrukturen als Plattform für Messungen der oberflächenverstärkten Raman-Streuung (SERS).

10. Verwendung nach Anspruch 9, **dadurch gekennzeichnet, dass** Para-Mercaptobenzoesäure als Modellmolekül in den Messungen eingesetzt wird.

11. Verwendung nach Anspruch 10, **dadurch gekennzeichnet, dass** vor der Durchführung der Messung die mit einer Goldschicht versehenen InP-Nanodrähte für 24 Stunden in eine Lösung von Para-Mercaptobenzoesäure eingetaucht, anschließend mit Wasser gespült und für 1 Stunde bei Raumtemperatur getrocknet werden.

## Revendications

1. Procédé de fabrication de nanostructures d'InP revêtues d'or, **caractérisé en ce que**
a) dans une première étape, des nanofils sont cultivés sur un substrat monocristallin d'InP par dépôt chimique en phase vapeur métal-organique, en introduisant de manière continue du triméthylindium et de la phosphine dans le réacteur,
le gaz vecteur étant l'hydrogène,
le rapport molaire entre le débit de phosphine et le débit de triméthylindium n'étant pas supérieur à 1000,
une température constante comprise entre 370 et 390°C et une pression de 100 mbar étant maintenues lors de l'introduction du triméthylindium et de la phosphine dans le réacteur;
b) dans une seconde étape, la surface des nanofils cultivés est recouverte d'une couche d'or par pulvérisation plasma avec un courant continu de 20 mA.

2. Procédé selon la revendication 1, **caractérisé en ce qu'**avant l'introduction du triméthylindium et de la phosphine dans le réacteur, le substrat monocristallin est soumis à un traitement thermique dans une atmosphère d'hydrogène à une température de 650°C pendant au moins 3 minutes.

3. Procédé selon la revendication 1 ou 2, **caractérisé en ce qu'**un substrat monocristallin présentant une orientation <111> est utilisé.

4. Procédé selon l'une quelconque des revendications 1 à 3, **caractérisé en ce qu'**un substrat monocristallin de dimensions 20 × 20 cm est utilisé.

5. Procédé selon l'une quelconque des revendications 1 à 4, **caractérisé en ce que** seul le triméthylindium est introduit dans le réacteur, l'introduction de la phosphine commençant après l'apparition des premières gouttelettes d'indium sur le substrat d'InP.

6. Procédé selon l'une quelconque des revendications 1 à 5, **caractérisé en ce que** le débit de triméthylindium est compris entre 10 et 20 ml/min.

7. Procédé selon l'une quelconque des revendications 1 à 6, **caractérisé en ce que** le débit de phosphine est de 300 ml/min.

8. Procédé selon l'une quelconque des revendications 1 à 7, **caractérisé en ce que** la pulvérisation plasma est effectuée pendant une durée de 3 à 7 minutes.

9. Utilisation des nanostructures d'InP revêtues d'or, obtenues selon le procédé de la revendication 1, en tant que plateforme pour les mesures de diffusion Raman amplifiée en surface (SERS).

10. Utilisation selon la revendication 9, **caractérisée en ce que** l'acide para-mercaptobenzoïque est utilisé comme molécule modèle lors des mesures.

11. Utilisation selon la revendication 10, **caractérisée en ce qu'**avant la mesure, les nanofils d'InP revêtus d'une couche d'or sont immergés pendant 24 heures dans une solution d'acide para-mercaptobenzoïque, puis rincés à l'eau et séchés pendant 1 heure à température ambiante.
